(19) Europäisches Patentamt

European Patent Office

Office européen des brevets

(11) **EP 2 685 489 A1**

(12) **EUROPEAN PATENT APPLICATION**
published in accordance with Art. 153(4) EPC

(43) Date of publication:
15.01.2014 Bulletin 2014/03

(51) Int Cl.:
*H01L 21/3065* (2006.01)

(21) Application number: 12754266.0

(22) Date of filing: 29.02.2012

(86) International application number:
PCT/JP2012/055091

(87) International publication number:
WO 2012/121081 (13.09.2012 Gazette 2012/37)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 07.03.2011 JP 2011049680

(71) Applicant: Mizuho Information & Research
Institute Inc.
Tokyo 101-8443 (JP)

(72) Inventors:
• ONO Kohei
Tokyo 101-8443 (JP)
• IWASAKI Takuya
Tokyo 101-8443 (JP)

(74) Representative: Isarpatent
Patent- und Rechtsanwälte
Friedrichstrasse 31
80801 München (DE)

(54) **DEVICE FOR ESTIMATING AND SIMULATING SHAPE WORKED BY PLASMA PROCESS, AND SIMULATION METHOD AND PROGRAM**

(57) A method and a program for predicting a processing shape by a plasma process, the method including: a conditions-setting step (STEP 11) for setting conditions relevant to an object to be processed, process conditions including a cycle number provided that an etching process and a deposition process are taken as one cycle, and conditions relevant to simulation; an etching process surface transition amount calculating step (STEP 12) for calculating a surface transition amount by plasma etching based on etching process conditions; and a deposition process surface transition amount calculating step (STEP 13) for calculating a surface transition amount by plasma deposition based on deposition process conditions, wherein the etching process surface transition amount calculating step (STEP 12) and the deposition process surface transition amount calculating step (STEP 13) are repeated for the cycle number set in the conditions-setting step (STEP 11), thereby obtaining a processing shape by the the Bosch process.

FIG. 6

EP 2 685 489 A1

**Description**

Technical Field

The present invention relates to a simulator, a method, and a program for predicting a processing shape of an object to be processed by a plasma process.

Background Art

The plasma etching process is one of semiconductor microfabrication technologies. Among them, Bosch process is for a vertical deep etching of semiconductor substrate (for example, see Patent Literature 1+). In this Bosch process, a deposition process and an etching process are repeated for several times as one cycle, wherein the deposition process is a process for forming an anti-etching film on a processing surface, and the etching process is a process for removing an anti-etching film formed on the hole bottom surface and for perform a further etching of the substrate.

Such an etching apparatus uses a high-frequency power source as a plasma generation source, for example, an object to be processed is placed in a chamber in which a vacuum pump exhausts gas including reactive gas flowing into the chamber from a gas introduction port, and the plasma generation source resolves the gas to change it to plasma. At that time, bias power such as direct current, alternate current, or high frequency is applied to the object to be processed to adjust an amount and energy of ions incident to the object to be processed. In The Bosch process, different mixed gas is iteratively used for the deposition process and the etching process. For example, $C_4F_8$ plasma is generated to form an anti-etching film on the bottom and side surface of the hole in the deposition process, while $SF_6$ plasma is generated in the etching process. The etching process can be divided into some steps: first, to remove the anti-etching film formed on the bottom surface of the hole formed in the deposition process, then to perform etching in the region in which the anti-etching film on the Si substrate is removed. This deposition process and etching process are repeated as one cycle, and thereby preventing lateral spread of etching of the Si substrate to form a hole  deeply extended in a depth direction keeping a side face vertical.

Citation List

Patent Literature

Patent Literature 1: JP 2007-129260A

Non-Patent Literature

Non-Patent Literature 1: A.MISAKA, K.HARAFUJI, M.KUBOTAAND N.NOMURA, "Novel Surface Reaction Model in Dry-Etching Process Simulator", JPN.J.APPL.PHYS 31 PAGE.4363-4669 (1992)

Summary of Invention

Technical Problem

The Bosch process requires a time and effort to perform a semiconductor microfabrication because optimization of process conditions and conditions to prevent an abnormal process are adjusted through trial and error relying on personal experience.
In view of the above, it is an objective of the present invention to provide a simulator for a processing shape by a plasma process, which can predict a processing shape of an object to be processed, which is formed by The Bosch process. Furthermore, it is an additional objective of the present invention to provide a method and a program for predicting simulation.

Solution to Problem

In order to achieve one of the above objective, a simulator for a processing shape by a plasma process, includes:

a conditions-setting unit for setting conditions relevant to an object to be processed, process conditions including a cycle number provided that an etching process and a deposition process are taken as one cycle, and conditions relevant to simulation;
a flux information database storing data relevant to energy distribution and/or distribution of irradiation angle of flux irradiated onto a processing surface of the object to be processed;

a chemical reaction database storing chemical reaction data of each process in etching and deposition;

a trajectory calculation unit for calculating electric field distribution generated by charged particles of the processing surface and for calculating a trajectory of charged particles incident on the processing surface;

a rate calculation unit for calculating an etching rate and a deposition rate by calculating each ion incident on the processing surface based on the trajectory of the charged particles obtained by the trajectory calculation unit and by calculating a reaction of the processing surface in each region using data stored in the flux information database and chemical reaction database;

a surface transition amount calculating unit for calculating a surface transition amount based on a difference between the etching rate and the deposition rate obtained by the rate calculation unit; and

a calculation control unit for repeating calculation of the surface transition amount by the surface transition amount calculating unit subject to the etching process conditions set by the conditions-setting unit, and calculation of the surface transition amount by the surface transition amount calculating unit subject to the deposition process conditions set by the conditions-setting unit, the calculations of surface transition amount being based on the conditions relevant to the object to be processed and the conditions relevant to the simulation set by the conditions-setting unit.

In order to achieve other objective, a predicting simulation method for predicting a processing shape by a plasma process, includes:

a conditions-setting step for setting conditions relevant to an object to be processed, process conditions including a cycle number provided that an etching process and a deposition process are taken as one cycle, and conditions relevant to simulation;

an etching process surface transition amount calculating step for calculating a surface transition amount by plasma etching based on etching process conditions; and

a deposition process surface transition amount calculating step for calculating a surface transition amount by plasma deposition based on deposition process conditions,

wherein the etching process surface transition amount calculating step and the deposition process surface transition amount calculating step are repeated for the cycle number set by the conditions-setting step to calculate a processing shape.

In order to still other objective, a predicting simulation program for predicting a processing shape by a plasma process, includes:

a conditions-setting step for setting conditions relevant to an object to be processed, process conditions including a cycle number provided that an etching process and a deposition process are taken as one cycle, and conditions relevant to simulation;

an etching process surface transition amount calculating step for calculating a surface transition amount by plasma etching based on etching process conditions; and

a deposition process surface transition amount calculating step for calculating a surface transition amount by plasma deposition based on deposition process conditions,

wherein the etching process surface transition amount calculating step and the deposition process surface transition amount calculating step are repeated for the cycle number set by the conditions-setting step to calculate a processing shape.

Advantageous Effects of Invention

According to the present invention, a shape processed by the Bosch process can be predicted. Thus, it enables easy setting of etching process conditions to remove an anti-etching film in the deposition process and easy searching to optimize The Bosch process.

Brief Description of the Drawings

FIG. 1 is a block diagram of a simulator for a processing shape by a plasma process according to the embodiment of the present invention.
FIG. 2 is a view schematically showing a substrate surface processed by a plasma etching.
FIG. 3 is a view showing the outline of the general calculation flow of the processing surface shape.

FIG. 4 is a view illustrating a method to describe a processing surface in a two-dimensional shape.

FIG. 5 is a view schematically showing a change of the shape calculated by the flow of Fig. 3.

FIG. 6 is a view showing the outline of flow of the predicting simulation method embodied by a simulation program for predicting the processing shape by a plasma process according to the embodiment of the present invention.

FIG. 7 is a view showing an early part of the detailed flow of the predicting simulation method of the processing shape by a plasma process shown in Fig. 6.

Fig. 8 is a view showing the remaining part of the flow shown in Fig. 7.

Fig. 9 is a flow diagram to find an optimum condition using a simulator for a processing shape by a plasma process according to the embodiment of the present invention.

Fig. 10 shows a modification of the embodiment according to the embodiment of the present invention and is a time chart of the process set in the conditions-setting unit shown in Fig. 1.

Fig. 11 is a cross sectional view of the hole predicted by a simulator for a processing shape by a plasma process according to the embodiment of the present invention. Fig. 11 (A) is a view showing the simulated result of a processing shape in the case of one-step etching process setting and Fig. 11 (B) is a view showing the simulated result of a processing shape in the case of two-step etching process setting.

Description of Embodiments

The following section will describe in detail some embodiments of the present invention with reference to the drawings.

[Plasma process simulated in the embodiments of the present invention]

The simulation implemented in the embodiments of the present invention is to predict a hole shape and its size formed by repeating a cycle of etching process and deposition process for several times after arranging a mask on a semiconductor substrate itself like Si or a substrate on which various films such as insulating film or metal film is laminated (hereafter, simply referred to as "an object to be processed"). This enables prediction of a cross-sectional shape of the hole, a hole shape in a depth direction and their sizes. This process itself is called as Bosch process and a well-known processing technology. In the Bosch process, an anti-etching film is formed in the deposition process to prevent a hole diameter from extending by etching a side surface of the hole when the hole is dug in the etching process.

The etching process can be mainly divided into a process to remove an anti-etching film formed on a bottom surface of the hole in the deposition process (hereafter, it simply referred to as "first etching process") and a process to deepen the hole after removing the anti-etching film on the bottom surface of the hole (hereafter, it referred to as "second etching process"). In the first etching process, for example, $SF_6$ plasma is used and, in order to remove the anti-etching film on the bottom, bias power applied in the stage to place an object to be processed is large. On the other hand, in the second etching process, for example, if the $SF_6$ plasma is used, bias power applied in the stage is small. This is considered because a hole is deeply dug in the second etching process and the anti-etching film of a side wall portion of the hole formed in the deposition process is hard to be removed.

In the conditions-setting unit 11, one or more selected from processing time, gaseous species, gas pressure, gas flow rate, temperature of an object to be processed and bias power is set as a parameter for each etching process, in the above-described example, for the first and second etching process. Bias power means power applied in the stage to place an object to be processed, for example, direct current, low frequency, high frequency, for example. The above-described parameter setting is changed in each etching process. Not different but the same one parameter may be set for each etching process. The etching process may be constituted of one process through a plurality of cycles. The etching process may be constituted of at least three processes for each cycle. Further, with regard to the process conditions in the deposition process, same as in the etching process, one or more selected from processing time, gaseous species, gas pressure, gas flow rate, temperature of an object to be processed and bias power may be set as a parameter. Accordingly, a series of processes is constituted of the etching process having one or more process conditions for each cycle and the deposition process having one or more process conditions for each cycle, and the number of each process conditions in the etching process and the deposition process may be same or different for each cycle.

The embodiments of the present invention can provide a guideline for the process conditions setting in an actual plasma process apparatus by simulating a hole shape formed by such a deep etching process.

[Simulator for a processing shape by a plasma process]

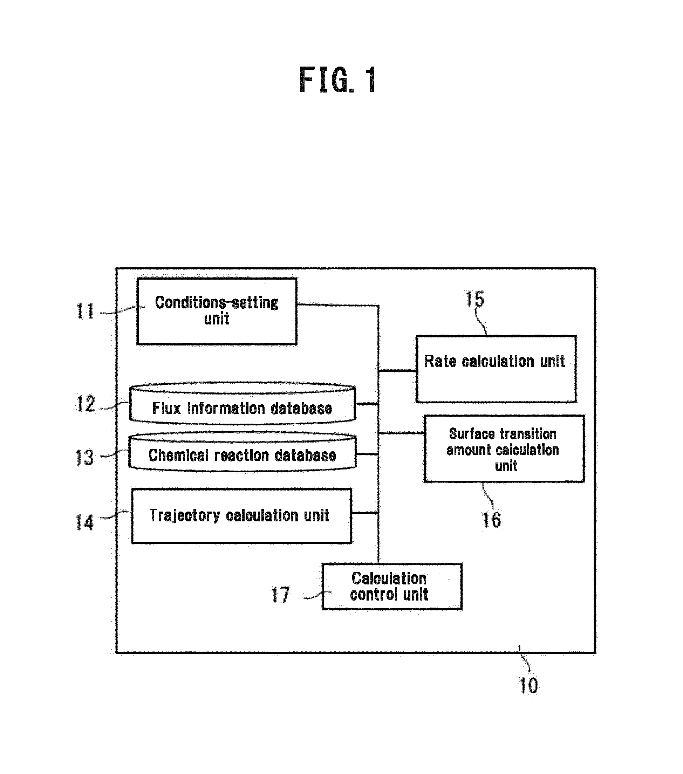

Fig. 1 is a block diagram of a simulator 10 for a processing shape by a plasma process according to the embodiment of the present invention. A simulator 10 for a processing shape by a plasma process according to the embodiment of the present invention includes: a conditions-setting unit 11; a flux information database 12; a chemical reaction database 13; a trajectory calculation unit 14; a rate calculation unit 15; a surface transition amount calculating unit 16; and a calculation control unit 17. This simulator 10 may implement each element of this simulator by executing a predicting simulation program for a processing shape by a plasma process on a computer. Therefore, the predicting simulation program for a processing shape by a plasma process may be stored in a recording medium readable by a computer. A program herein means a combination of orders to a computer to obtain a result. Although not shown in Fig. 1, the simulator issues an order to start a simulation, necessary orders to display a simulation result, an input order to conditions-setting unit 11 for example, and includes an input and output unit including a display to display a simulation result.

The details of each structure of the simulator shown in Fig. 1 will be described.

The conditions-setting unit 11 is for setting various conditions, such as conditions of an object to be processed, conditions regarding a process, and conditions regarding a simulation.

The condition item regarding the object to be processed includes a shape and size of the object and a mask, that are deepen-etched, and the condition regarding the object to be processed includes a boundary condition.

The condition regarding the process includes etching conditions, deposition conditions, the cycle number. The item for both etching and deposition conditions includes processing time, gaseous species, gas pressure, gas flow rate, temperature of the object to be processed and bias power. It is unnecessary to fix the etching and deposition conditions in one cycle and different etching and deposition conditions may be set in one cycle. The number of etching and deposition conditions in one cycle may be arbitrarily set depending on the cycle order and may be arbitrarily set regardless of the cycle number.

Conditions regarding simulation, whose details will be described later, include a mesh, a time unit, a string division number.

The flux information database 12 stores data regarding the flux irradiated on a processing surface. The data for charged particle flux and radical one are stored separately.

The data item regarding charged particle flux includes ion species, energy distribution, angle distribution, intensity. Depending on the conditions regarding a process, which are set by the conditions-setting unit 11, the data item includes data regarding energy distribution, angle distribution, intensity of the charged particle, and result of angle distribution of ion flux obtained by the trajectory calculation unit 14, wherein the charged particle includes electron and various ions such as $Cl_2^+$, $SF_5^+$.

The data item regarding radical flux includes radical species, energy distribution, angle distribution, and intensity. Depending on the conditions regarding process, which are set by the conditions-setting unit 11, the item includes the data regarding energy distribution, angle distribution, and intensity of various radical fluxes such as $CF_3^*$, $F^*$, $O^*$.

The chemical reaction database 13 stores the chemical reaction data in the respective process of etching and deposition. The chemical reaction data includes the data required for trajectory calculation by the trajectory calculation unit 14 and the data required for reaction calculation by the surface transition amount calculating unit 16. Therefore, the chemical reaction database 13 stores the data regarding material physicality and surface reaction. For example, the chemical reaction database 13 stores data regarding the permittivities or conductivities of the respective materials, the ion species mass and the electron mass. The data is used in the trajectory calculation unit 14 that performs analysis using the Poisson equation and the Newton's equation of motion. The chemical reaction database 13 respectively stores the coefficients for the reactions required in a radical adsorption reaction calculation, an ion reaction calculation, and a thermal excitation-type chemical reaction calculation in the surface transition amount calculating unit 16. As the surface transition amount calculating unit 16 requires the data such as reaction formula, radical and ion adsorption rate, desorption rate, activation energy, angle and energy distribution when a reaction product is re-emitted from the surface, these data are also stored in the chemical reaction database 13.

The following section will describe the reaction formulas stored in chemical reaction database 13.

For example, the following is a chemical reaction in the etching process. As a reaction in ion and etching process,

$$SFx^+ + SiF_4 \dashrightarrow F(2)^*$$

can be provided. Ion $SFx^+$ leads an etching reaction of evaporant $SiF_4$ on a processing surface to desorb a reaction product $F(2)^*$. The value of desorption rate is set as a function of energy and angle or as a constant independent from them. In the meantime, (2) in $F(2)^*$ is a sign to distinguish from $F^*$, not indicated herein.

Further, as a reaction in an adsorb process of neutral particles,

$$F(2)^* + Si \dashrightarrow Si(2)$$

can be provided. Neutral particle radical F(2)* reacts with Si on a processing surface to generate an evaporant Si(2). The value of adsorption rate is set as a function of energy and angle or as a constant independent from them. In the meantime, (2) in Si(2) is a sign to distinguish from Si, not indicated herein.

Furthermore, as a reaction in the thermal excitation etching process,

$$SiF_4(s) \dashrightarrow SiF_4(g)$$

can be provided. $SiF_4(s)$ on a processing surface is desorbed as $SiF_4(g)$ by thermal excitation. The values of reaction coefficient and activation energy are set as a function of energy and angle or as a constant independent from them.

On the other hand, in a reaction in the deposition process, as a reaction in an adsorb process of neutral particles,

$$C_xF_y^* + Si \dashrightarrow Si\_c$$

can be provided. $C_xF_y^*$ is adhered on Si to form Si_c. The value of adsorption rate is set as a function of energy and angle or as a constant independent from them.

Such information regarding the reaction formulas is stored in the chemical reaction database 13 together with the adsorption rate of radical and ion, desorption rate of radical and ion, activation energy, angle and energy distribution when a reaction product is re-emitted from the surface.

As the material property data, the chemical reaction database 13 stores, in addition to the combination of the name of a reaction product at a substrate surface and any of etching or deposition, the particle number density (e.g., the atom number density or the molecule number density), the surface density of the adsorption site, the relative permittivity, the annihilation factor, the conductivity of conductive material, the electrical property (e.g., whether conductive or insulating), the light absorption coefficient of each wavelength, and the defect generation coefficient for each wavelength for example. The term "material" herein means such material that forms a reaction product and a substrate material. On the other hand, surface reaction data includes data regarding a neutral particle adsorption model, an ion reaction model, and a thermal excitation-type chemical reaction model, respectively. Data items regarding the neutral particle adsorption reaction model include: the name of a reactive product by the adsorption reaction; the adsorption rate of each incident radical and each reaction product; the angle dependence of the radical adsorption; and the radical reflectivity for example. Data items regarding the ion reaction model include: a combination of a substrate material or reaction product name having an ion assist reaction and an ion name; a desorption rate; and a reaction rate of an ion assist reaction for example. Data items regarding the thermal excitation-type chemical reaction model include a reaction coefficient of a thermal excitation-type chemical reaction; and an activation energy for example.

The trajectory calculation unit 14, calculating the trajectories of charged particles required by the rate calculation unit 15, calculates the trajectories of charged particles incident on a processing surface from plasma based on a density and energy distribution of electrons or ions incident on the processing surface, and charge distribution on the processing surface. The trajectory calculation unit 14 calculates a potential distribution based on a boundary condition regarding the object to be processed set by the conditions-setting unit 11 or updated by a calculation by the trajectory calculation unit 14, kind and density of the radical and ions inputted or updated in the flux information database 12, material value of the material such as permittivity and conductivity inputted in the chemical reaction database 13, ion species, mass of atom, for example, and then calculates electron and ion trajectories flowing into the substrate. Specifically, the Poisson equation is solved based on the accumulated charge distribution at the processing surface to thereby calculate the electric field caused by the charge accumulation distribution. Thereafter, based on the electric field distribution, the trajectories of the charged particles flowing into the substrate surface are calculated.

Based on the calculated ion trajectories, the ion flux distribution is calculated as a function of the energy and angle. These values may be stored in the flux information database 12 and may be used for the calculation by the rate calculation unit 15.

The rate calculation unit 15 performs a reaction calculation in the respective region of the processing surface based on the data stored in the flux information database 12 or the chemical reaction database 13, and performs a reaction calculation in the respective region of the processing surface based on the kind and amount of ions incident on the processing surface through the trajectories of charged particles, obtained by the trajectory calculation unit 14. Thereby, the etching rate and deposition rate are obtained. Specifically, the rate calculation unit 15 calculates, based on conditions (e.g., the respective flux densities of the radicals and ions flowing from plasma, the adsorption probability to the surface of the object to be processed, the chemical reaction rate, and the reflectivity), the etching rate and the deposition rate of each material at each point on the processing surface.

The surface transition amount calculating unit 16 calculates surface transition amount based on the difference between the etching rate and the deposition rate, obtained by the rate calculation unit 15, to thereby calculate, for example, a temporal change of the cross-sectional shape of the wafer. Details of the calculation will be described later.

The rate calculation unit 15 and the surface transition amount calculating unit 16 calculate surface transition amount due to the radical adsorption reaction, the ion assist reaction, and the thermal excitation-type chemical reaction based on the calculation results by the trajectory calculation unit 14 while referring to the data stored in the chemical reaction database 13.

The calculation control unit 17 repeats the following two calculation processings based on the conditions regarding the simulation set by the conditions-setting unit 11. One calculation processing is for calculating a surface transition amount by the surface transition amount calculating unit 16 following the conditions regarding the process in the etching process set by the conditions-setting unit 11. The other calculation processing is for calculating a surface transition amount by the surface transition amount calculating unit 16 following the conditions regarding the process in the deposition process set by the conditions-setting unit 11. The repeat count is determined by the cycle number set as conditions regarding the process in the conditions-setting unit 11.

The simulator 10 for processing a shape by a plasma process, shown in Fig. 1, performs a simulation of the Bosch process in the following way. In advance, the conditions-setting unit 11 sets conditions regarding the object to be processed, process, and simulation. Then, while the calculation control unit 17 uses trajectory calculation unit 14 and the rate calculation unit 15, the surface transition amount calculating unit 16 calculates the etching amount by etching and the accumulation amount by deposition. At that time, the data stored in the flux information database 12 and the chemical reaction database 13 are referenced, respectively.

Furthermore, by setting, for example, etching time and bias power of each cycle in order of the etching process conditions as a parameter for the conditions-setting unit 11, the calculation control unit 17 controls the surface transition amount calculating unit 16 based on the conditions set by the conditions-setting unit 11. Thereby, the surface transition amount is calculated for each cycle in order of the etching process condition. When one or more parameter is selected from processing time, gaseous species, gas pressure, gas flow rate, temperature of the object to be processed and bias power, it is unnecessary to be a combination of etching time as processing time and bias power.

[Predicting simulation method for processing a shape by a plasma process]

The following section will describe the method of simulating the processing shape using the simulator 10 for predicting the processing shape by a plasma process according to an embodiment of the present invention.

[Assumption]

First, as an assumption for the explanation of how to predict the processing shape by a plasma process, how to describe the state of the processing surface and how to describe a change of the surface state will be explained conceptually.

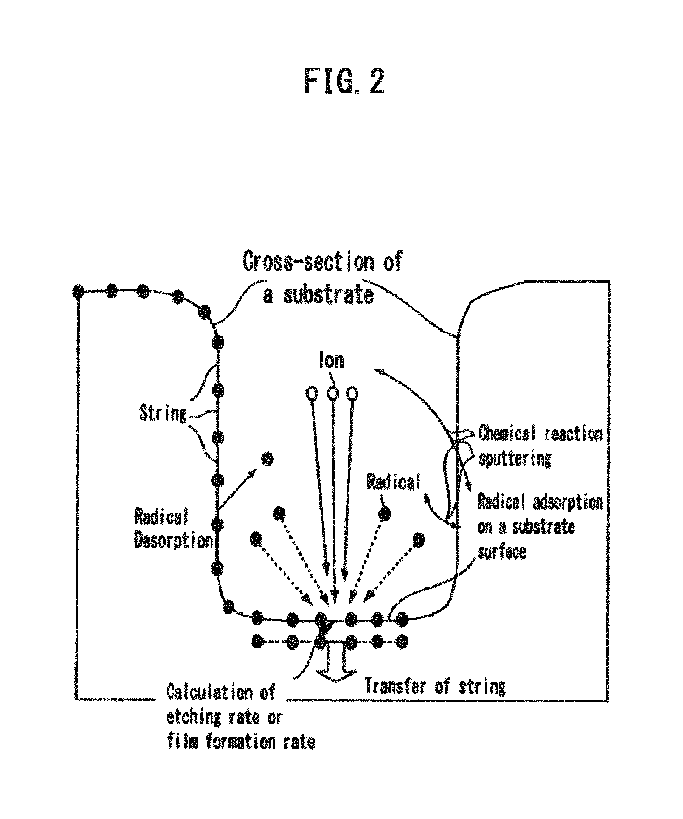

Fig. 2 is a view schematically showing a substrate surface processed by a plasma etching. When the substrate surface is subjected to ion etching, the processing surface includes therein a chemical reaction and sputtering. Thus, the contour of the substrate surface is firstly represented by discrete black points (●) that are connected by straight lines. The straight lines are called strings.

When radicals or ions are incident on the surface, the surface has a chemical reaction or sputtering and radicals are adsorbed or desorbed on the substrate surface. They are represented by a deposition rate and an etching rate. A difference between these rates is used to calculate the etching rate or film formation rate to transfer the strings. Although the following section will describe a two-dimensional shape, the description also can be applied to a three-dimensional shape. Furthermore, the direction of deposition by plasma is just the reversed direction of string in the schematic view of Fig. 2.

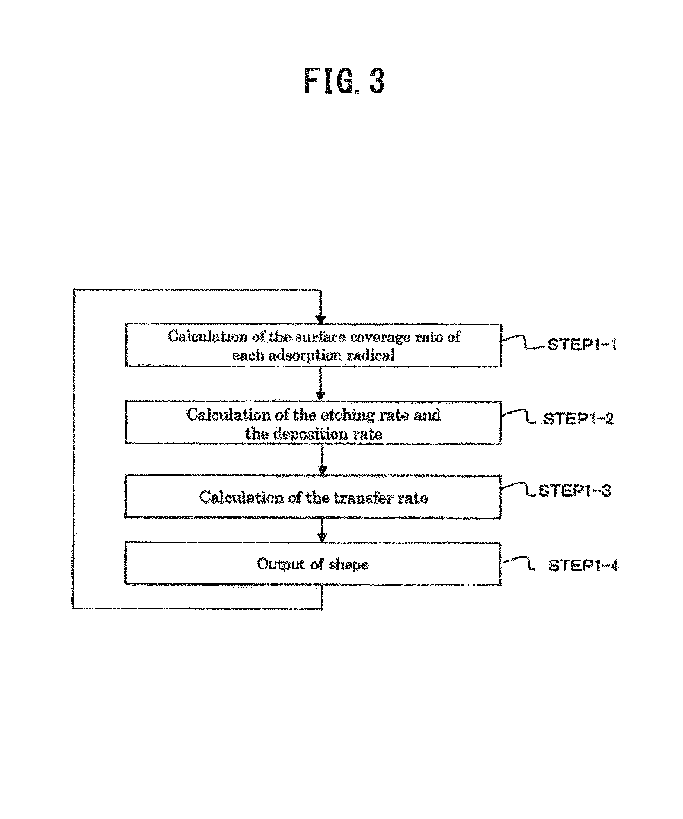

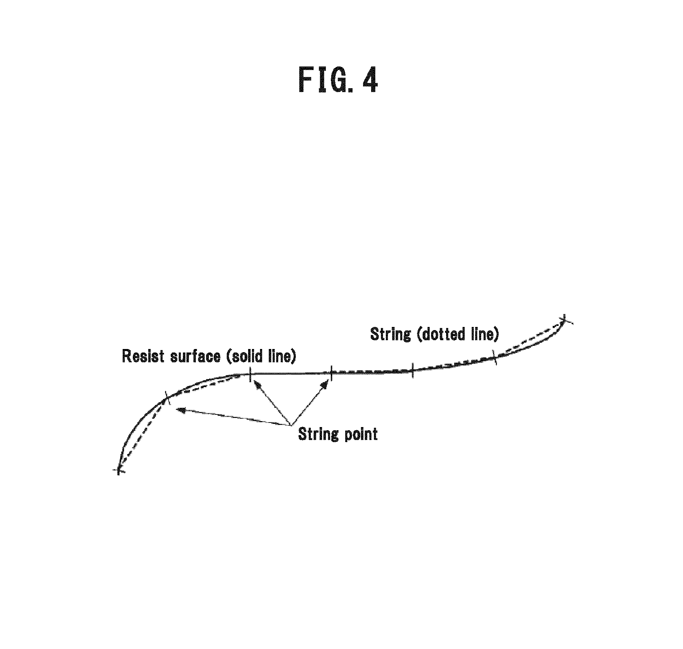

Fig. 3 is a view showing the outline of the general calculation flow of the processing surface shape. As shown in Fig. 4, the resist surface shown by the solid line is divided by string points (generally, "the respective points on the processing surface") and the neighboring string points are approximated by strings as shown by the dotted line (generally "elements"). How to describe the surface reaction on this string will be considered. When it is assumed that the surface occupation rate of the substrate material is $\theta_0$, the surface occupation rate of the material m is $\theta_m$, and the surface density of the adsorption site is $\delta_s$, the following equation is established as a binding condition.

[Formula 1]

$$\theta_0(P,t) + \sum_{m=1}^{N} \theta_m(P,t) = 1 \qquad (1)$$

[Formula 2]

$$\theta_m(P,t) \geqq 0 \qquad \text{for } m = 0,1,\cdots,N \quad (2)$$

When assuming that the generation number of the material m per a unit time is $G_m$ and the disappearance number of the material m per a unit time is $H_m$, then the following basic equation is established.
[Formula 3]

$$\sigma_s \frac{d\theta_0}{dt}(P,t) = -\sum_{m=1}^{N}[G_m(P,t) - H_m(p,t)] \qquad (3)$$

[Formula 4]

$$\sigma_m \frac{d\theta_m}{dt}(P,t) = G_m(P,t) - H_m(P,t) \qquad (4)$$

Thus, by solving the basic equations based on the binding condition, the surface coverage rate of each adsorption radical is calculated (STEP1-1). The material m also may be called a radical.
Next, the etching rate and the deposition rate are calculated (STEP1-2). The etching rate is calculated as a sum of the etching rate by the thermal excitation-type chemical reaction, the etching rate by the physical sputtering, and the etching rate by the ion assist reaction. The deposition rate is calculated as a sum of the deposition rate caused by the accumulation effect of the deposition substance, the deposition rate by the generation of the deposition substance, and the deposition rate by the ion assist reaction. The etching rate and the deposition rate by plasma are calculated as shown by the following formula (Non-Patent Literature 1).
Specifically, the etching rate ER is decomposed as shown by the formula (5). $ER_{total}$ is the etching rate by the thermal excitation-type chemical reaction at the surface covered with the adsorption radical. $ER_{physical}$ is the etching rate by the physical sputtering to the clean surface of the to-be-etched material by high energy ions. $ER_{ionassisted}$ is the etching rate by the physical and chemical sputterings (also called "ion assist reaction") to the surface covered with the adsorption radical by high energy ions.
[Formula 5]

$$ER_{total} = ER_{thermal} + ER_{physical} + ER_{ionassisted} \qquad (5)$$

The respective etching rates $ER_{thermal}$, $ER_{physical}$, and $ER_{ionassisted}$ can be calculated as shown below. The thermal excitation-type chemical reaction etching rate $ER_{thermal}$ at the point P is represented by the formula (6).
[Formula 6]

$$ER_{\text{thermal}}(P) = \frac{1}{\rho} \sum_{\text{n}} k_0^{(n)} \theta_{\text{n}}(P) \exp\left(-\frac{E_a^{(n)}}{k_B T}\right) \qquad (6)$$

In the formula, $\rho$ is a substrate density, $k_0^{(n)}$ is the coefficient related to the radical n, $\theta_n$ is a surface occupation rate of the radical n, $E_a^{(n)}$ is an activation energy, $k_B$ is a Boltzmann constant, and T is a substrate temperature. As can be seen from the formula (6), $ER_{\text{thermal}}$ is a sum for the radical n.

The etching rate $ER_{\text{physical}}$ by the physical sputtering at the point P is represented by the formula (7).

[Formula 7]

$$ER_{physical}(P) = \frac{1}{\rho} \sum_{i} \int_0^{\varepsilon_{max}} Y_i^{physical}(\varepsilon) F_i(P, \varepsilon) \theta_0(P) d\varepsilon \qquad (7)$$

In the formula, $\varepsilon_{max}$ is the maximum energy of incident ion. $Y_i^{physical}(\varepsilon)$ is the physical sputtering yield by the ion i. $F_i(P, \varepsilon)$ is the flux of the incident ion i having the energy $\varepsilon$ at the point P. $\theta_0(P)$ is a clean substrate surface occupation rate at the point P. As can be seen from the formula (7), $ER_{\text{physical}}$ is a sum for both ions i of the reactive ions and non-reactive ions.

The etching rate $ER_{\text{ionassisted}}$ by the ion assist reaction at the point P is represented by the formula (8).

[Formula 8]

$$ER_{ion\,assisted}(P) = \frac{1}{\rho} \sum_{i} \sum_{j} \int_0^{\varepsilon_{max}} Y_{ij}^{ion\,assisted}(\varepsilon) F_i(P, \varepsilon) \theta_j(P) d\varepsilon \qquad (8)$$

In the formula, $\varepsilon_{max}$ is the maximum energy of incident ion. $Y_{ij}^{ionassisted}(\varepsilon)$ is the yield at which the radical j by the ion i is desorbed from a surface reaction layer. $F_i(P, \varepsilon)$ is the flux of the incident ion i having the energy $\varepsilon$ at the point P. $\theta_j(P)$ is a substrate occupation rate of the radical j at the point P. $ER_{\text{ionassisted}}$ is a sum of both ions i of the reactive ions and non-reactive ions and a sum of entire radical j including the substrate surface material.

The deposition rate DR can be decomposed as shown in the formula (9). The first term of the right side of the formula (9) represents a deposition rate due to the accumulation effect of the deposition substance. The second term of the formula (9) represents a deposition rate due to the effect by the deposition substance generated by the reaction between the incident radical and the radicals of the surface reaction layer. The third term of the formula (9) represents a deposition rate by the effect by the deposition substance desorbed from the surface reaction layer due to the ion assist reaction.

[Formula 9]

$$DR_{total}(P) = DR^{(1)}(P) + DR^{(2)}(P) - DR^{(3)}(P) \qquad (9)$$

The deposition rate due to the accumulation effect by the deposition substance at the point P is represented by the formula (10).

[Formula 10]

$$DR^{(1)}(P) = \frac{1}{\rho_d} \sum_{m} \left[ \sigma_{m0}(\varepsilon) \theta_0(P) + \sum_{k} \sigma_{mk}(\varepsilon) \theta_k(P) \right] F_m(P) \qquad (10)$$

In the formula, $\rho_d$ represents the deposition layer density. $\sigma_{m0}(\varepsilon)$ represents an adsorption rate between the radical m and the clean to-be-etched material film. $\sigma_{mk}(\varepsilon)$ represents the adsorption rate between the radical m and the adsorption layer film of the radical k formed on the to-be-etched material film. $\varepsilon$ represents the energy of the radical m.

As can be seen from the formula (10), the radicals k formed on the to-be-etched material film are added for all k substituted with the radicals m and m is added for all of the deposition substances.

The formula (11) shows the deposition rate caused by the effect by the deposition substance generated by the reaction at the point P between the incident radicals having the energy $\varepsilon$ and the radicals at the surface reaction layer.

[Formula 11]

$$DR^{(2)}(P) = \frac{1}{\rho_d} \sum_m \sum_{l \neq m} \left[ \sigma_{l0}^{(m)}(\varepsilon)\theta_0(P) + \sum_{k \neq m} \sigma_{lk}^{(m)}(\varepsilon)\theta_k(P) \right] F_l(P) \qquad (11)$$

In the formula, $\sigma_{lo}^{(m)}(\varepsilon)$ represents the generation rate at which the deposition substance m is generated by the reaction between the flying radicals 1 and the clean to-be-etched material film. $\sigma_{lk}^{(m)}(\varepsilon)$ represents the generation rate at which the deposition substance m is generated by the reaction between the flying radicals 1 and the adsorption film layer of the radicals k formed on the to-be-etched material film.

The reaction at the point P caused when ions having the energy $\varepsilon$ are incident and the deposition substance is desorbed from the surface reaction layer is generally called an ion assist reaction. The deposition rate based on the effect by this ion assist reaction is represented by the formula (12).

[Formula 12]

$$DR^{(3)}(P) = \frac{1}{\rho_d} \sum_m \sum_{l \neq m} \int_0^{\varepsilon_{max}} \left[ \sum_l Y_{lm}^{(l)}(\varepsilon) \right] \theta_m(P) F_i(P, \varepsilon) d\varepsilon \qquad (12)$$

In the formula, $\rho_d$ represents the deposition layer density. $Y_{im}^{(l)}(\varepsilon)$ represents the yield of the reaction product 1 desorbed from the surface reaction layer in consideration of the fact that the deposition substance m is decomposed to the radicals 1.

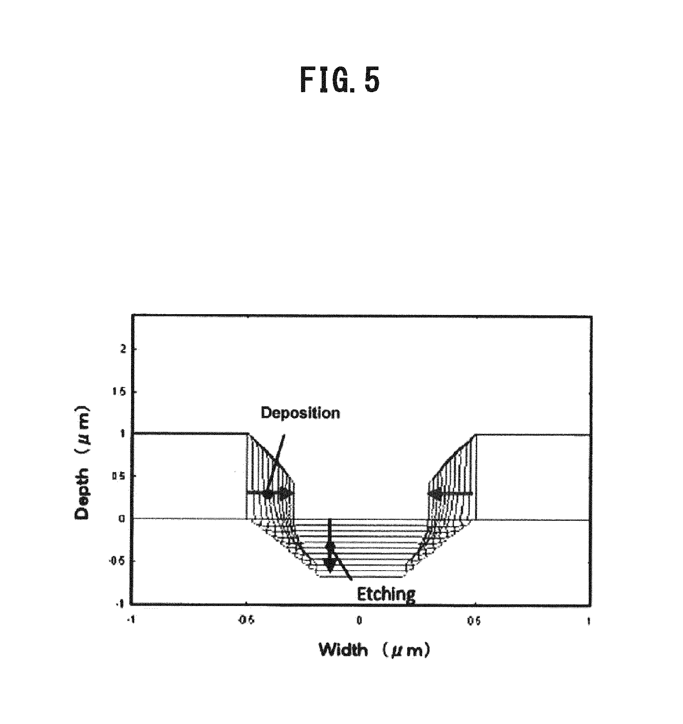

Next, the transfer rate of each string P is calculated (STEP1-3). Specifically, when the difference between the etching rate and the deposition rate shows that the etching rate is higher than the deposition rate, then the etching is carried out. When the difference between the etching rate and the deposition rate shows that the etching rate is lower than the deposition rate on the other hand, then the deposition is carried out. Then, by connecting the string points describing the surface at an arbitrary time, the surface transfer rate can be calculated to thereby calculate the shape of the substrate surface at the arbitrary time. Thus, the result regarding the shape can be outputted and displayed (STEP1-4). Fig. 5 shows a change of the shape thus calculated.

[Outline of the predicting simulation method of a processing shape by a plasma process]

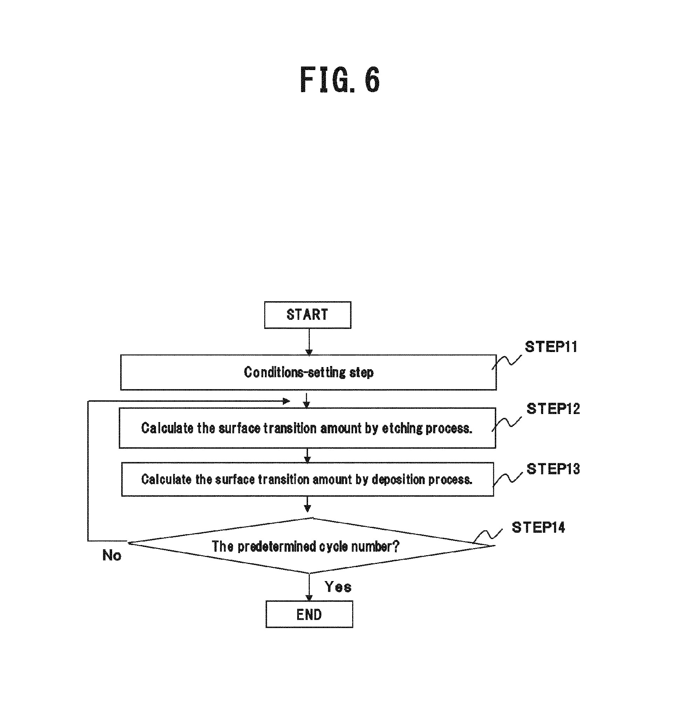

The outline of the predicting simulation method of a processing shape using a simulator 10 for a processing shape by a plasma process, shown in Fig. 1, will be described. Fig. 6 is a view showing the outline of flow of the predicting simulation method embodied by a simulation program for predicting the processing shape by a plasma process according to the embodiment of the present invention. As shown in Fig. 6, a predicting simulation method of a processing shape by a plasma process includes: a conditions-setting step STEP 11 for setting conditions regarding an object to be processed, conditions in the respective process including a cycle number provided that an etching process and a deposition process are taken as one cycle, and conditions regarding simulation; an etching process surface transition amount calculating step STEP 12 for calculating a surface transition amount by plasma etching based on etching process conditions; and a deposition process surface transition amount calculating step STEP 13 for calculating a surface transition amount by plasma deposition based on deposition process conditions. The etching process surface transition amount calculating step STEP 12 and the deposition process surface transition amount calculating step STEP 13 are repeated for a predetermined cycle number (i.e., until STEP 14 results in "yes") to predict a formed shape.

[Trajectory calculation of charged particles, calculation of a processing surface shape]

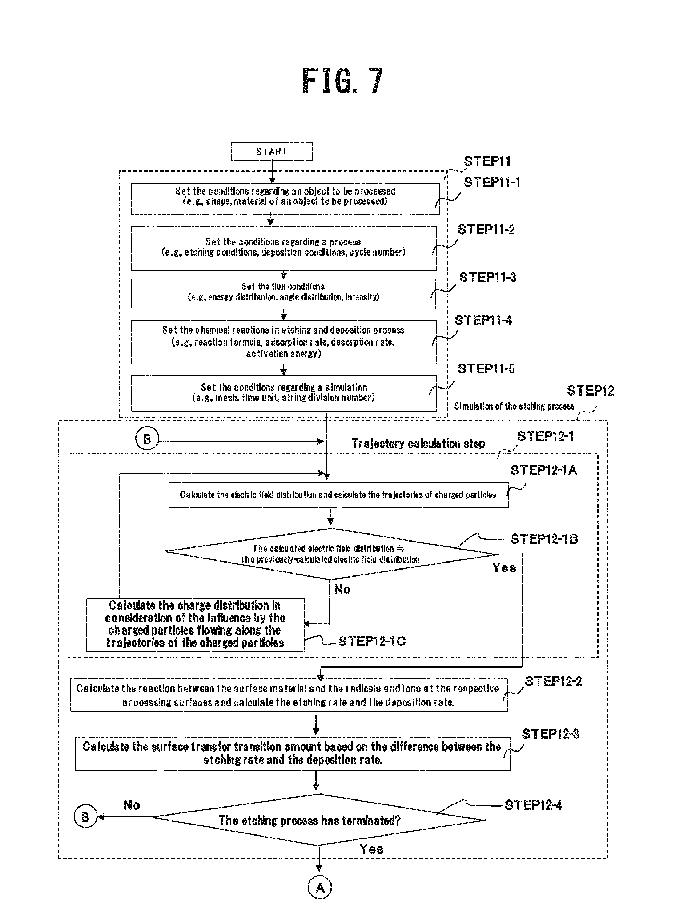

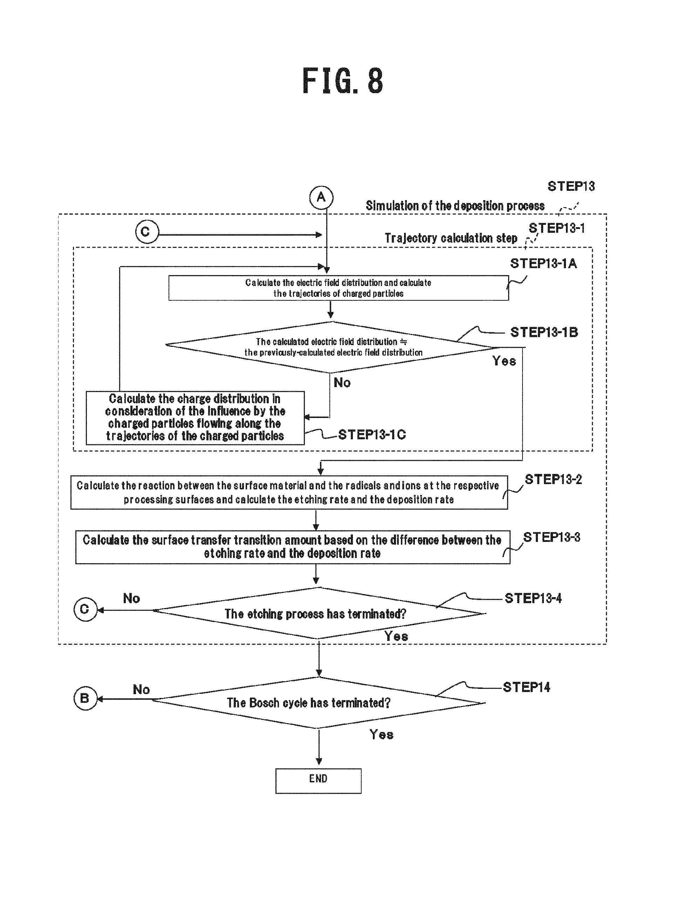

The following section will describe in detail the predicting simulation method of a processing shape by a plasma process according to the embodiment of the present invention, while explaining how the surface transition amount calculating unit 16, shown in Fig. 1, uses the trajectory calculation unit 14 and the rate calculation unit 15 to predict a surface processing shape. FIG. 7 is a view showing an early part of the detailed flow of the predicting simulation method of the processing shape by a plasma process shown in Fig. 6. Fig. 8 is a view showing the remaining part of the flow shown in Fig. 7.

In STEP 11, conditions regarding an object to be processed, a cycle number and conditions in the respective process when etching process and deposition process are taken as one cycle, and conditions regarding simulation are set by input operation, and a radiation flux setting, a chemical reaction in the etching and deposition process are set with reference to the flux information database 12 and the chemical reaction database 13.

Specifically, in STEP 11-1, conditions regarding the object to be processed such as shape and size of mask and the object to be processed are set in addition to material of the object to be processed including boundary conditions.

In STEP 11-2, as conditions regarding a process, etching process conditions and deposition process in the Bosch process, cycle number, for example are set. Specifically, for example, time ratio or respective time of the etching process and the deposition process in one cycle, time ratio or respective time of a process to remove an anti-etching film on the hole bottom in the etching process and a process to dig into the hole bottom surface from which the anti-etching film was removed, cycle number, and repeat count of one cycle of the process to dig into the hole are set. At that time, whether bias power is applied or not, its volume, for example are also set.

In STEP 11-3, each radical data item is set based on the conditions regarding the process, set in STEP 11-2, with reference to the flux information database 12. The angle distribution, the energy distribution, for example when a reaction product is re-emitted from the surface are also set.

In STEP 11-4, the chemical reaction in the etching and deposition process is set. Specifically, the material physicality data and the data regarding a surface reaction corresponding to the kind of the object to be processed, gaseous species for example, set in the STEP 11-1 and STEP 11-2, with reference to the chemical reaction database 13, a reaction formula, adsorption and desorption rate of radical and ions, activation energy, for example are obtained.

In STEP 11-5, as conditions regarding a simulation, the mesh, the time unit, the string division number, for example are set. For example, regions of the substrate as a processing object are divided as a plurality of elements (meshes). Then, material types are set to the elements corresponding to the substrate regions. By setting the regions of a part as a mask, the regions of the processing surface are determined.

As described above, in STEP 11, the elements of the surface to be simulated (or strings when the shape is the two-dimensional one) are set and move to a cycle loop.

The cycle loop is performed in order of the etching process simulation and the deposition process simulation.

In the etching process simulation (STEP 12), the trajectory calculation step for calculation of electric field distribution and trajectory calculation of the charged particles (STEP 12-1) is performed repeatedly until a steady state is achieved. First, trajectory calculation and ion flux distribution setting are performed.

The trajectory calculation unit 14 performs the trajectory calculation to calculate potential distribution based on: the boundary condition regarding the object to be processed, set by the conditions-setting unit 11 or updated by the calculation by the trajectory calculation unit 14; the kind and density of radical and ions inputted or updated by the flux information database 12; and material value of the material inputted in the chemical reaction database 13 such as permittivity and conductivity, ion species, and mass of atoms. The trajectory calculation unit 14 solves the Poisson equation based on the charge accumulation amount at the processing surface as the boundary condition to thereby calculate the electric field distribution to calculate the respective trajectories of the ions and electrons based on the Newton's equation of motion. The electric field distribution is calculated. Thus, in consideration of the acceleration of charged particles due to the difference in the potential, the respective rates and travel directions of the ions and electrons can be accurately calculated.

Specifically, in STEP 12-1A, the charge distribution of the processing surface is calculated based on an assumption that the incident ions and electrons have reached the processing surface. Then, the electric field distribution is calculated by solving the Poisson equation based on the charge accumulation amounts at the respective points at the processing surface as a boundary condition. Furthermore, based on the electric field distribution, the trajectories of the respective charged particles including the ions and electrons are calculated based on the Newton's equation of motion.

In STEP 12-1B, it is determined whether the calculated electric field distribution is substantially the same as the previously-calculated electric field distribution or not. When it is determined that the former is not within the same range, it is determined that the respective ions and electrons flow based on the trajectories of the respective ions and the trajectories of the respective electrons. Then, a new charge distribution is calculated (STEP 12-1C). Then, the processing returns to STEP 12-1A. When it is determined that the electric field distribution calculated by STEP12-1A is substantially the same as the previously-calculated electric field distribution (i.e., it is determined that the electric field distribution is convergent), then the electric field distribution at the processing surface is steady. Thus, based on the trajectories and rates of the respective ions, the electric field distribution can be set as a function of the angle and energy regarding the ions incident on the respective points at the processing surface. A sufficient amount of the trajectory calculation is preferably performed so as to sufficiently reduce a variation in the statistic amount. If a function already stored in the flux information database 12 is available, the function can be used by the trajectory calculation unit 14.

Next, in STEP 12-2, the rate calculation unit 15 performs the following reaction calculation based on the trajectories of the charged particles obtained by the STEP 12-1 and incident distribution of energy and angle of respective radical species inputted as a parameter with reference to the flux information database 12 depending on the input conditions. First, the incident energy or the incident angle for example are set for all types of particles involved in the surface reaction of the particles, regarding the reaction to adsorb charged particles and radicals for example incident on the processing surface from the outside or to desorb the adsorbed charged particles and radicals from the processing surface. Then, based on the respective reaction coefficients at the respective points on the processing surface, the etching rate and the deposition rate are respectively calculated based on the ions incident on the respective points of the processing surface along the trajectories calculated in the trajectory calculation step and the incident flux distribution of the radicals.

Next, as STEP 12-3, based on a difference between the etching rate and the deposition rate, the surface transition amount of respective processing surface is calculated.

The following section will describe in detail the calculation of the surface transition amount obtained in the above STEP 12-2 and STEP 12-3.

In STEP 12-2, based on the flux conditions set in STEP 11-3 and the respective reaction coefficients calculated in STEP 11-4, the reaction between the surface material and the radicals at each processing surface as well as the reaction between the surface material and the ions are calculated repeatedly until each material has a steady coverage rate. As a result, the etching rate and the deposition rate are calculated, respectively. The etching rate is calculated, as shown in the above-described formula (5), as a sum of the etching rates by the thermal excitation-type chemical reaction, the physical sputtering, and the ion assist reaction, respectively. The deposition rate is calculated, as shown in the above-described formula (9), as a sum of the deposition rates by the accumulation effect of the deposition substance, the generation of the deposition substance, and the ion assist reaction. By calculating the respective rates in consideration of the respective coefficients of these reactions, the transfer transition of the processing surface is calculated. Then, in STEP 12-3, the transfer transition amount of the processing surface is calculated based on the difference between the etching rate and the deposition rate.

Next, in STEP 12-4, based on transfer rates at the respective points of the processing surface obtained by the calculation process of surface transition amount of STEP 12-3, whether the processing amount or the processing time set under the processing conditions is satisfied or not is determined. When the processing amount or the processing time set under the processing conditions is not satisfied, the processing returns to STEP 12-1 to reset the respective points at the processing surface. Then, the processing returns to the trajectory calculation step. Specifically, when the etching amount calculated in STEP 12-3 does not reach the etching amount, the respective points of the surface are reset and the processing returns to STEP 12-1 repeatedly. On the other hand, when the etching amount calculated in STEP 12-3 reaches the setup etching amount, this etching process loop is discontinued and move to the deposition process. The repetition of the loop processing also may be determined not based on the etching amount but based on the etching time.

As shown in Fig. 8, also in the deposition process simulation (STEP 13), same calculation performed in the etching process simulation (STEP 12) is performed. Specifically, in the deposition process, the calculation of electric field distribution and trajectory calculation of the charged particles (STEP 13-1) is performed repeatedly until a steady state is achieved. Until the trajectory calculation unit 14 results in "yes" in STEP 13-1A and STEP 13-1B, STEP 13-1C and STEP 13-1A are repeated. Next, in STEP 13-2, based on the respective reaction coefficients at the respective points on the processing surface, the rate calculation unit 15 calculates the etching rate and the deposition rate based on the ions incident on the respective points of the processing surface along the trajectories calculated in the trajectory calculation step (STEP 13-1) and the incident flux distribution of the radicals. At that time, reaction calculation is performed in the same calculation method as in the etching process based on the trajectories of the charged particles obtained in STEP 13-1 and the incident distribution of the charged particles. The energy and angle of the incident distribution for the respective radical species is inputted as a parameter with reference to the flux information database 12, for example.

Next, in STEP 13-3, the surface transition amount is calculated based on the difference between the etching rate and the deposition rate obtained in STEP 13-2. Then, in STEP 13-4, it retunes to STEP 13-1 if the deposition process is not terminated.

Then, the cycle constituted of the etching and deposition process is repeated for predetermined times, set by the Bosch process conditions (STEP 11-2).

As described above, an embodiment according to the present invention includes: a conditions-setting step for setting conditions relevant to an object to be processed, process conditions including the cycle number provided that an etching process and a deposition process are taken as one cycle, and conditions relevant to simulation; an etching process surface transition amount calculation step for calculating a surface transition amount by plasma etching based on the etching process conditions; and a deposition process surface transition amount calculating step for calculating a surface transition amount by plasma deposition based on the deposition process conditions. The etching process surface transition amount calculating step and the deposition process surface transition amount calculating step are repeated for the cycle number set by the condition setting step to calculate a processing shape. Therefore, a processing shape formed by the Bosch process can be easily predicted.

A processing shape in the Bosch process can be predicted, and thereby allowing easier conditions setting to remove an anti-etching film formed by the deposition process and easier search for the optimum condition of the Bosch process.

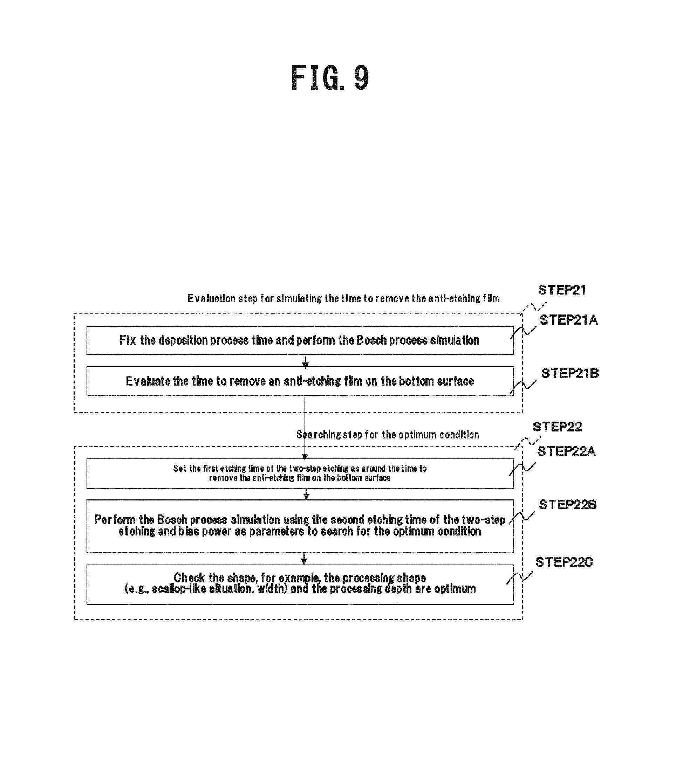

Fig. 9 is a flow diagram to find an optimum condition using a simulator 10 for a processing shape by a plasma process according to the embodiment of the present invention.

In STEP 21, in the anti-etching film formed in the deposition process, the required time to remove an anti-etching film accumulated on the hole bottom by etching process is simulated. First, the time to accumulate the anti-etching film in the deposition process is fixed and a plurality of values are set as the time for the etching process, in accordance with the flow shown in the Fig. 7 and Fig. 8, The Bosch process is simulated for each of the setting etching process times (STEP 21A). Then, from these results, the required time to remove the anti-etching film on the hole bottom is estimated (STEP 21B). Thereby, the required time to remove the anti-etching film, accumulated in the region of the hole bottom by the deposition process in a certain period of time, can be predicted.

Next, in STEP 22, the optimum conditions detection step by The Bosch process is performed. In The Bosch process, an etching process is divided into the etching process to remove the anti-etching film on the hole bottom (first etching process) and the etching process to dig into the hole thereafter (second etching process).

The time obtained in STEP 21 is set as the time to remove the anti-etching film on the hole bottom in the first etching process (STEP 22A).

Next, used etching time and RF bias power in the second etching process as a parameter, The Bosch process is simulated (STEP 22B) in accordance with the flow shown in Fig. 7 and Fig. 8. By simulating The Bosch process using a plurality of values as parameter, the optimum condition can be searched for.

For example, based on the predicted processing shape, specifically, such as a scallop-like situation, a hole width and a processing hole depth, it can be determined whether the shape is optimum or not (STEP 22C).

Thus, how process conditions should be set for an actual plasma process apparatus can be predicted by the simulation.

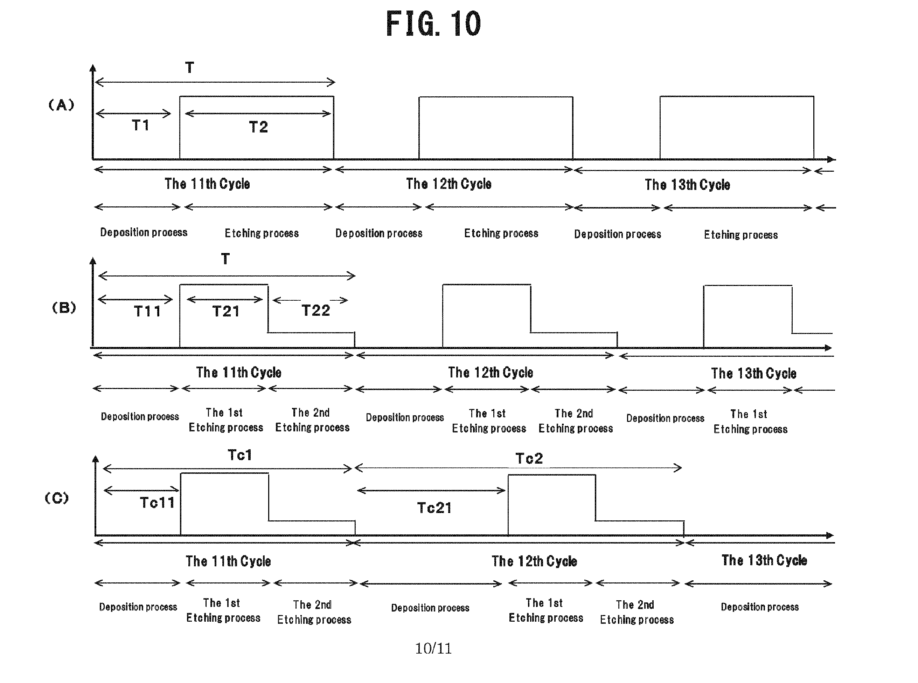

Fig. 10 shows a modification of the embodiment according to the embodiment of the present invention and is a time chart of process set in conditions-setting unit 11 shown in Fig. 1. The horizontal axis in the figure represents time and the vertical axis represents an applied bias power. Fig.10 (A) illustrates a version one deposition process and one etching process are set in one cycle as processing time T1 and T2 respectively, and the conditions set in the respective cycle are not changed.

Fig. 10 (B) illustrates a version one deposition process and two etching processes are set in one cycle as processing time T11, T21, and T22 respectively, and the conditions set in the respective cycle are not changed in the cycle order.

Fig. 10 (C) illustrates a version one deposition process and two etching processes are set in one cycle, however, different from Fig.10 (B), Tc11, one of the processing times in the deposition process, can be changed for each cycle.

Further, not shown in the figure, the process number in the deposition and etching process can be changed depending on the cycle.

As described above, in the conditions-setting unit 11, regarding process conditions setting, one or more selected from processing time, gaseous species, gas pressure, gas flow rate, temperature of the object to be processed and bias power are arbitrarily set as a parameter.

The following section will describe the actual simulation results.

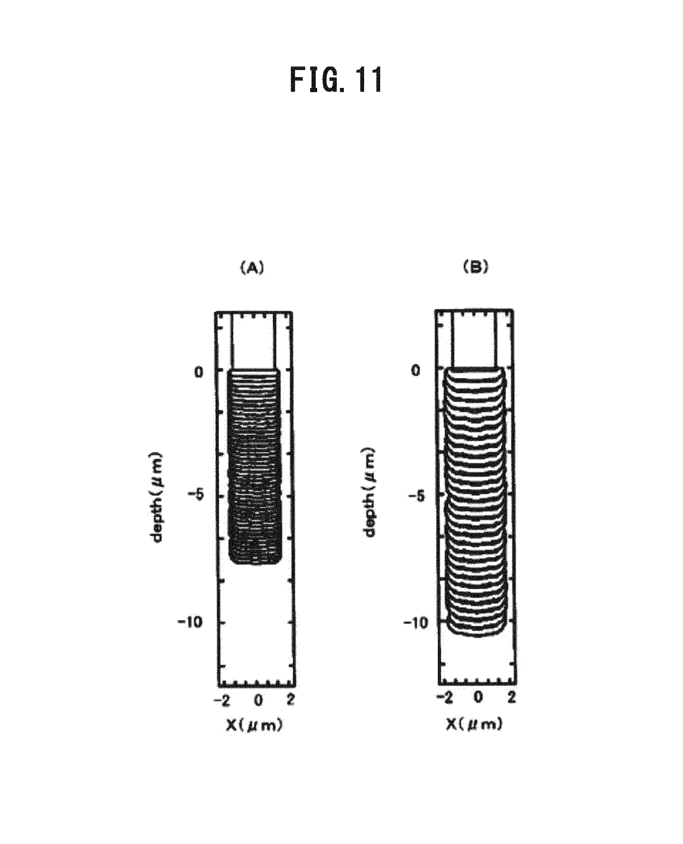

Fig. 11 is a cross sectional view of the hole predicted by a simulator for a processing shape by a plasma process according to the embodiment of the present invention. Fig. 11 (A) is a view showing the simulated result of a processing shape in the case of one-step etching process setting and Fig. 11 (B) is a view showing the simulated result of a processing shape in the case of two-step etching process setting. Fig. 11 (A) and Fig. 11 (B), time charts respectively shown in Fig. 10 (A) and Fig. 10 (B), are the simulated results. In Fig.11 (A) and Fig.11 (B), respectively, because the processing time for each cycle is same, it turns out that the depths are the same. Further, because the process conditions regarding the etching and deposition in the respective cycle are same in Fig.11 (A) and Fig.11 (B) respectively, it turns out that the dug shapes for each cycle are the same.

As described above, since various parameters in The Bosch process can be set for simulation, the shape and size of a hole formed by The Bosch process can be predicted. Thereby, in addition to optimization of apparatus conditions, the embodiments of the present invention can contribute to the foundation of a new device.

Reference Signs List

10: Simulator for a processing shape by a plasma process
11: Conditions-setting unit
12: Flux information database
13: Chemical reaction database
14: Trajectory calculation unit
15: Rate calculation unit
16: Surface transition amount calculation unit
17: Calculation Control unit

**Claims**

1. A simulator for a processing shape by a plasma process, comprising:

a conditions-setting unit for setting conditions relevant to an object to be processed, process conditions including a cycle number provided that an etching process and a deposition process are taken as one cycle, and conditions relevant to simulation;
a flux information database storing data relevant to energy distribution and/or distribution of irradiation angle of flux irradiated onto a processing surface of the object to be processed;
a chemical reaction database storing chemical reaction data of each process in etching and deposition;
a trajectory calculation unit for calculating electric field distribution generated by charged particles of the processing surface and for calculating a trajectory of charged particles incident on the processing surface;
a rate calculation unit for calculating an etching rate and a deposition rate by calculating each ion incident on the processing surface based on the trajectory of the charged particles obtained by the trajectory calculation unit and by calculating a reaction of the processing surface in each region using data stored in the flux information database and chemical reaction database;
a surface transition amount calculating unit for calculating a surface transition amount based on a difference between the etching rate and the deposition rate obtained by the rate calculation unit; and
a calculation control unit for repeating calculation of the surface transition amount by the surface transition amount calculating unit subject to the etching process conditions set by the conditions-setting unit, and calculation of the surface transition amount by the surface transition amount calculating unit subject to the deposition process conditions set by the conditions-setting unit, the calculations of surface transition amount being based on the conditions relevant to the object to be processed and the conditions relevant to the simulation set by the conditions-setting unit.

2. The simulator for a processing shape by a plasma process according to claim 1,
wherein the conditions-setting unit enables setting of one or more selected from processing time, gaseous species, gas pressure, gas flow rate, temperature of the object to be processed, and bias power as a parameter for a plurality of processes constituting of either etching or deposition process, or both etching and deposition process,
wherein the calculation control unit calculates a surface transition amount for each cycle in order of the plurality of the process conditions by controlling the surface transition amount calculating unit subject to the parameter and the conditions relevant to process set by the conditions-setting unit.

3. A predicting simulation method for predicting a processing shape by a plasma process, comprising:

a conditions-setting step for setting conditions relevant to an object to be processed, process conditions including a cycle number provided that an etching process and a deposition process are taken as one cycle, and conditions relevant to simulation;
an etching process surface transition amount calculating step for calculating a surface transition amount by plasma etching based on etching process conditions; and
a deposition process surface transition amount calculating step for calculating a surface transition amount by plasma deposition based on deposition process conditions,
wherein the etching process surface transition amount calculating step and the deposition process surface transition amount calculating step are repeated for the cycle number set by the conditions-setting step to calculate a processing shape.

4. The predicting simulation method for predicting a processing shape by a plasma process according to claim 3, wherein one or more selected from processing time, gaseous species, gas pressure, gas flow rate, temperature of an object to be processed, and bias power is set as a parameter for a plurality of processes constituted of either etching or deposition process, or both etching and deposition process, and
wherein the surface transition amount is calculated for each parameter set in the conditions-setting step in either etching or deposition process surface transition amount calculating step, or both etching and deposition process surface transition amount calculating step.

5. A predicting simulation program for predicting a processing shape by a plasma process, comprising:

a conditions-setting step for setting conditions relevant to an object to be processed, process conditions including a cycle number provided that an etching process and a deposition process are taken as one cycle, and conditions relevant to simulation;
an etching process surface transition amount calculating step for calculating a surface transition amount by plasma etching based on etching process conditions; and
a deposition process surface transition amount calculating step for calculating a surface transition amount by plasma deposition based on deposition process conditions,
wherein the etching process surface transition amount calculating step and the deposition process surface transition amount calculating step are repeated for the cycle number set by the conditions-setting step to calculate a processing shape.

6. The predicting simulation program for predicting a processing shape by a plasma process according to claim 5, wherein one or more selected from processing time, gaseous species, gas pressure, gas flow rate, temperature of an object to be processed, and bias power is set as a parameter for a plurality of processes constituted of either etching or deposition process, or both etching and deposition process, and
wherein the surface transition amount is calculated for each parameter set in the conditions-setting step in either etching or deposition process surface transition amount calculating step, or both etching and deposition process surface transition amount calculating step.

# FIG. 1

11 — Conditions-setting unit

15

Rate calculation unit

12 — Flux information database

13 — Chemical reaction database

Surface transition amount calculation unit

16

14 — Trajectory calculation unit

17 — Calculation control unit

10

# FIG. 2

Cross-section of a substrate

Ion

String

Radical Desorption

Radical

Chemical reaction sputtering

Radical adsorption on a substrate surface

Calculation of etching rate or film formation rate

Transfer of string

# FIG. 3

```
┌─────────────────────────────────────────────┐
│                                              │
│   ┌──────────────────────────────────────┐   │
└──▶│  Calculation of the surface coverage  │───── STEP1-1
    │      rate of each adsorption radical  │
    └──────────────────────────────────────┘
                      │
                      ▼
    ┌──────────────────────────────────────┐
    │   Calculation of the etching rate and │───── STEP1-2
    │          the deposition rate          │
    └──────────────────────────────────────┘
                      │
                      ▼
    ┌──────────────────────────────────────┐
    │     Calculation of the transfer rate  │───── STEP1-3
    └──────────────────────────────────────┘
                      │
                      ▼
    ┌──────────────────────────────────────┐
    │            Output of shape            │───── STEP1-4
    └──────────────────────────────────────┘
```

# FIG. 4

String (dotted line)

Resist surface (solid line)

String point

# FIG. 5

# FIG. 6

```
                    ┌──────────────┐
                    │    START     │
                    └──────┬───────┘
                           │
    ┌──────────────────────▼──────────────────────┐     STEP11
    │         Conditions-setting step              │
    └──────────────────────┬──────────────────────┘
  ┌─────────────────────────▼─────────────────────────┐   STEP12
  │ Calculate the surface transition amount by etching process. │
  └─────────────────────────┬─────────────────────────┘
  ┌─────────────────────────▼─────────────────────────┐   STEP13
  │ Calculate the surface transition amount by deposition process. │
  └─────────────────────────┬─────────────────────────┘
                            │
              ◇─────────────▼─────────────◇              STEP14
    No ───────  The predetermined cycle number?  
              ◇─────────────┬─────────────◇
                            │ Yes
                    ┌──────▼───────┐
                    │     END      │
                    └──────────────┘
```

EP 2 685 489 A1

# FIG. 7

START

STEP11

STEP11-1
Set the conditions regarding an object to be processed
(e.g., shape, material of an object to be processed)

STEP11-2
Set the conditions regarding a process
(e.g., etching conditions, deposition conditions, cycle number)

STEP11-3
Set the flux conditions
(e.g., energy distribution, angle distribution, intensity)

STEP11-4
Set the chemical reactions in etching and deposition process
(e.g., reaction formula, adsorption rate, desorption rate,
activation energy)

STEP11-5
Set the conditions regarding a simulation
(e.g., mesh, time unit, string division number)

STEP12
Simulation of the etching process

B → Trajectory calculation step  STEP12-1

STEP12-1A
Calculate the electric field distribution and calculate the trajectories of charged particles

STEP12-1B
The calculated electric field distribution ≒
the previously-calculated electric field distribution

No          Yes

Calculate the charge distribution in
consideration of the influence by the
charged particles flowing along the
trajectories of the charged particles
STEP12-1C

STEP12-2
Calculate the reaction between the surface material and the radicals and ions at the respective
processing surfaces and calculate the etching rate and the deposition rate.

STEP12-3
Calculate the surface transfer transition amount based on the difference between the
etching rate and the deposition rate.

STEP12-4
No
B ← The etching process has terminated?

Yes

A

22

# FIG. 8

STEP13

(A) Simulation of the deposition process

(C) → Trajectory calculation step STEP13-1

STEP13-1A

Calculate the electric field distribution and calculate the trajectories of charged particles

STEP13-1B

The calculated electric field distribution ≑ the previously-calculated electric field distribution

Yes

No

Calculate the charge distribution in consideration of the influence by the charged particles flowing along the trajectories of the charged particles

STEP13-1C

Calculate the reaction between the surface material and the radicals and ions at the respective processing surfaces and calculate the etching rate and the deposition rate — STEP13-2

Calculate the surface transfer transition amount based on the difference between the etching rate and the deposition rate — STEP13-3

(C) ← No

The etching process has terminated? — STEP13-4

Yes

(B) ← No

The Bosch cycle has terminated? — STEP14

Yes

END

# FIG. 9

Evaluation step for simulating the time to remove the anti-etching film — STEP21

> Fix the deposition process time and perform the Bosch process simulation — STEP21A
>
> Evaluate the time to remove an anti-etching film on the bottom surface — STEP21B

Searching step for the optimum condition — STEP22

> Set the first etching time of the two-step etching as around the time to remove the anti-etching film on the bottom surface — STEP22A
>
> Perform the Bosch process simulation using the second etching time of the two-step etching and bias power as parameters to search for the optimum condition — STEP22B
>
> Check the shape, for example, the processing shape (e.g., scallop-like situation, width) and the processing depth are optimum — STEP22C

# FIG. 10

The 11th Cycle     The 12th Cycle     The 13th Cycle

(A)

T

T1    T2

Deposition process    Etching process    Deposition process    Etching process    Deposition process    Etching process

(B)

T

T11    T21    T22

The 11th Cycle     The 12th Cycle     The 13th Cycle

Deposition process   The 1st Etching process   The 2nd Etching process   Deposition process   The 1st Etching process   The 2nd Etching process   Deposition process   The 1st Etching process

(C)

Tc1     Tc2

Tc11    Tc21

The 11th Cycle     The 12th Cycle     The 13th Cycle

Deposition process   The 1st Etching process   The 2nd Etching process   Deposition process   The 1st Etching process   The 2nd Etching process   Deposition process

10/11

# FIG. 11

(A)                    (B)

| | | |
|---|---|---|
| **INTERNATIONAL SEARCH REPORT** | | International application No. |
| | | PCT/JP2012/055091 |

**A.  CLASSIFICATION OF SUBJECT MATTER**
*H01L21/3065*(2006.01)i

According to International Patent Classification (IPC) or to both national classification and IPC

**B.  FIELDS SEARCHED**

Minimum documentation searched (classification system followed by classification symbols)
H01L21/3065, G06F19/00

Documentation searched other than minimum documentation to the extent that such documents are included in the fields searched
Jitsuyo Shinan Koho          1922–1996   Jitsuyo Shinan Toroku Koho   1996–2012
Kokai Jitsuyo Shinan Koho    1971–2012   Toroku Jitsuyo Shinan Koho   1994–2012

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| Y | JP 2007-234867 A  (Toshiba Corp.),<br>13 September 2007 (13.09.2007),<br>paragraphs [0018] to [0062]; fig. 1 to 7<br>(Family: none) | 1-6 |
| Y | JP 2006-514783 A  (Lam Research Corp.),<br>11 May 2006 (11.05.2006),<br>paragraphs [0036] to [0045]; fig. 4A to 4F<br>& WO 2004/034445 A2     & KR 10-2005-0118267 A<br>& CN 1723549 A           & AU 2003282718 A | 1-6 |
| Y | JP 2008-529313 A  (Lam Research Corp.),<br>31 July 2008 (31.07.2008),<br>paragraphs [0048] to [0054]; fig. 9A to 9C<br>& WO 2006/083592 A1     & DE 112006000308 T<br>& KR 10-2007-0100420 A  & CN 101164143 A | 1-6 |

| ☐  Further documents are listed in the continuation of Box C. | ☐  See patent family annex. |
|---|---|

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| 21 May, 2012 (21.05.12) | 29 May, 2012 (29.05.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007129260 A

**Non-patent literature cited in the description**

- **A.MISAKA ; K.HARAFUJI ; M.KUBOTAAND N.NOMURA.** Novel Surface Reaction Model in Dry-Etching Process Simulator. *JPN.J.APPL.PHYS,* 1992, vol. 31, 4363-4669